# EUROPEAN PATENT APPLICATION

(11) **EP 1 752 734 A2**
(43) Date of publication of application: **14.02.2007**
(21) Application number: 06254161.0
(22) Date of filing: 08.08.2006
(51) Int. Cl.: G01C 19/56, H01L 23/00

(54) **Semiconductor device**

(30) Priority: 09.08.2005 JP 2005231363
(71) Applicant: Fujitsu Media Devices Limited, Yokohama-shi, Kanagawa 222-0033 (JP); Fujitsu Ltd., Kawasaki-shi, Kanagawa 211-8588 (JP)
(72) Inventor: Yamaji, Takayuki,c/o Fujitsu Media Devices Limited, Yokohama-shi, Kanagawa 222-0033 (JP); Ishikawa, Hiroshi, c/o Fujitsu Limited, Kawasaki-shi, Kanagawa 211-8588 (JP); Katsuki, Takashi, c/o Fujitsu Limited, Kawasaki-shi, Kanagawa 211-8588 (JP); Takahashi, Yuji, c/o Fujitsu Limited, Kawasaki-shi, Kanagawa 211-8588 (JP); Nakazawa, Fumihiko, c/o Fujitsu Limited, Kawasaki-shi, Kanagawa 211-8588 (JP); Sano, Satoshi, c/o Fujitsu Limited, Kawasaki-shi, Kanagawa 211-8588 (JP)
(74) Representative: Hitching, Peter Matthew

(57) **Abstract**

A semiconductor device includes a chip having a base semiconductor layer (10), an insulation layer (12) provided on the base semiconductor layer, and an upper semiconductor layer (14) provided on the insulation layer; a mounting substrate (30) on which the chip is mounted at the base semiconductor layer; and a connecting portion (22) that electrically couples first terminals (32) provided on the mounting substrate and a surface or second terminals (19) provided thereon of the base semiconductor layer.

## Description

### BACKGROUND OF THE INVENTION

### 1. Field of the Invention

This invention generally relates to semiconductor devices, and more particularly, to a semiconductor device having a SOI structure and including a minute driving portion that mechanically drives.

### 2. Description of the Related Art

There is disclosed an angular velocity sensor used to detect a rotational angular velocity of an object in Japanese Patent Publication No. 07-3337, as a semiconductor device that employs a SOI substrate. There is also disclosed a micro mirror device used as an optical switch in Japanese Patent Application Publication No. 2003-15064. The above-described semiconductor devices have double gimbal portions. For example, in the angular velocity sensor, the angular velocity is detected by vibrating one gimbal portion to detect the other. In the micro mirror device, the mirror portion is driven by driving one gimbal portion around x-axis and driving the other around y-axis. In this manner, in each of the above-described semiconductor devices, there is provided a driving portion that mechanically drives the gimbal portion.

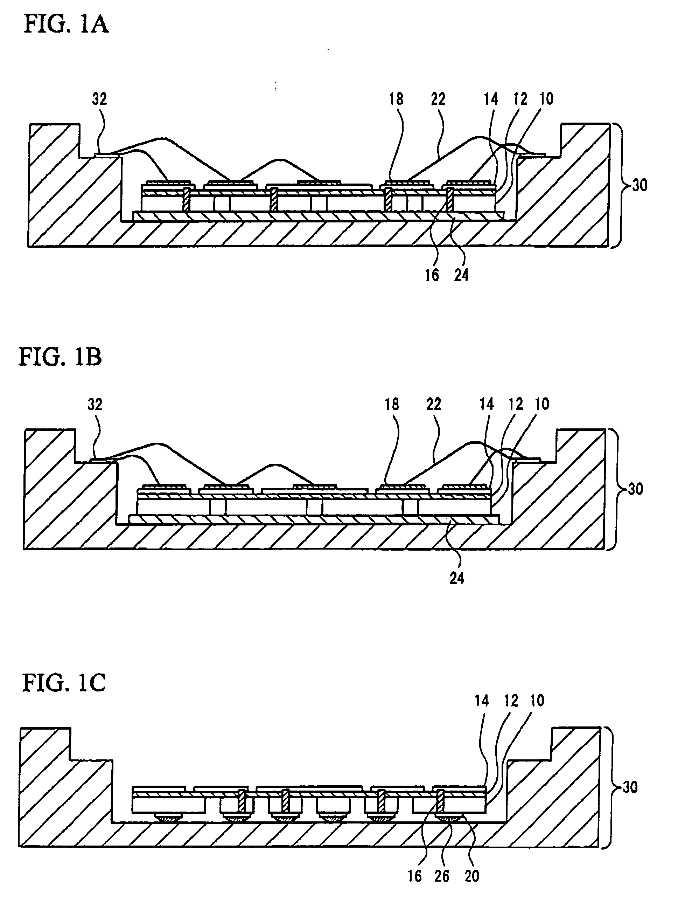

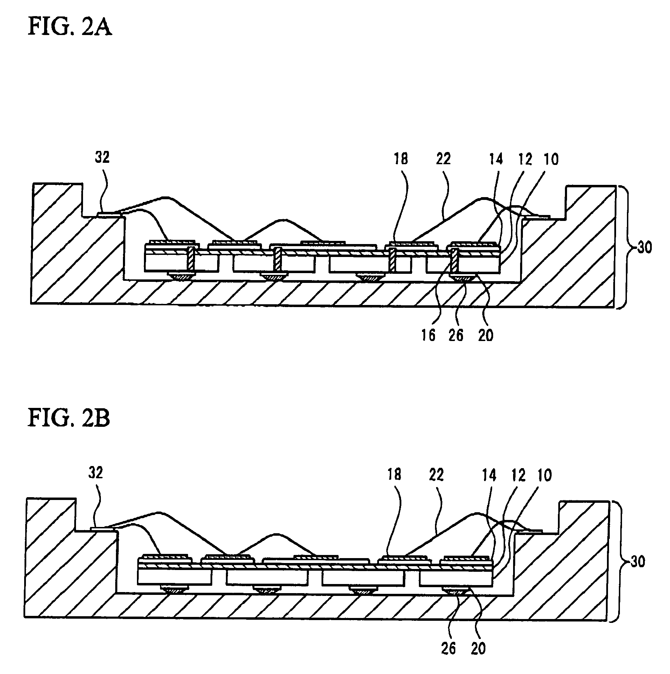

Referring to FIG. 1A through FIG. 2B, a description will be given of a semiconductor device that employs a conventional SOI substrate. FIG. 1A is a cross-sectional view of the semiconductor device of conventional example 1. A chip of SOI structure is die bonded to a stacked package 30 by a bonding material 24. The chip has a SOI structure in which a base semiconductor layer 10, an insulation layer 12, and an upper semiconductor layer 14 are stacked. Electrodes 18 are formed on the upper semiconductor layer 14, and are connected to pads 32 of the stacked package 30 by wires 22. In addition, connecting holes 16 are provided in the insulation layer 12 and a metal is provided in the connecting holes 16, so the base semiconductor layer 10 is coupled to the upper semiconductor layer 14 and further coupled to the electrodes 18. As stated, in the conventional example 1, the chip is die bonded to the stacked package 30 and the electrodes 18 on the upper semiconductor layer 14 are wire bonded to the stacked package 30, so the upper semiconductor layer 14 and the base semiconductor layer 10 are electrically coupled to the stacked package 30.

FIG. 1B is a cross-sectional view of the semiconductor device of conventional example 2. This is an example in which the base semiconductor layer 10 is not electrically coupled. Except that the connecting holes 16 are not provided, the same components and configurations of FIG. 1A are employed. In the conventional example 2, the chip is die bonded to the stacked package 30 and the electrodes 18 on the upper semiconductor layer 14 are wire bonded to the stacked package 30, so the upper semiconductor layer 14 is electrically coupled to the outside.

FIG. 1C is a cross-sectional view of the semiconductor device of conventional example 3. The electrodes 20 are provided on the backside of the base semiconductor layer 10, bumps 26 are provided at the electrodes 20, and the chip is mounted on the stacked package 30. In addition, the connecting holes 16 are provided in the insulation layer 12 and a metal is provided in the connecting holes 16, so the upper semiconductor layer 14 and the base semiconductor layer 10 are electrically coupled to the stacked package 30.

FIG. 2A is a cross-sectional view of the semiconductor device of conventional example 4. The electrodes 20 are provided on the backside of the base semiconductor layer 10, and the chip is mounted on the stacked package 30 by the bumps 26. In addition, the electrodes 18 are provided on the upper semiconductor layer 14, so the electrodes 18 and the pads 32 are connected by the wires 22. The upper semiconductor layer 14 and the base semiconductor layer 10 are coupled by providing a metal in the connecting holes 16. In the conventional example 4, the upper semiconductor layer 14 and the base semiconductor layer 10 are electrically coupled to the stacked package 30 by the bumps 26 and the wires 22.

FIG. 2B is a cross-sectional view of the semiconductor device of conventional example 5. The electrodes 20 are provided on the backside of the base semiconductor layer 10, and the chip is mounted on the stacked package 30 by using the bumps 26. In addition, the electrodes 18 are provided on the upper semiconductor layer 14, so the electrodes 18 and the pads 32 are connected by the wires 22. In the conventional example 5, the base semiconductor layer 10 and the stacked package 30 are electrically coupled by the bumps 26, and the upper semiconductor layer 14 is electrically coupled to the stacked package 30 by the wires 22.

In the conventional examples 3 through 5, the base semiconductor layer 10 is connected to the stacked package 30 by the bumps 26. However, during the formation process of the bumps 26, ultrasonic waves are applied or thermal compression bonding is performed to connect the bumps and the stacked package 30. There is a drawback that the chip is damaged during the formation process. For example, in the above-described angular velocity sensor or the micro mirror device, it is likely to damage the gimbal portion, the driving portion that drives the gimbal portion, or a torsion bar that retains the gimbal portion. There is another drawback that the mounting surface cannot be inspected after the chip is mounted. Meanwhile, in the conventional examples 1 and 2, it is possible to avoid the drawback that the chip is damaged during the formation process of the bumps 26 and the drawback that the mounting surface cannot be inspected after the chip is mounted, since the bumps 26 are not provided. Nevertheless, in the conventional example 1, the base semiconductor layer 10 is coupled to the stacked package 30 via the connecting holes 16, thereby increasing the chip area and the inductance. In the conventional example 2, the base semiconductor layer 10 cannot be coupled to the stacked package 30.

### SUMMARY OF THE INVENTION

The present invention has been made in view of the above circumstances and provides a semiconductor device in which it is easy to electrically couple a chip to the outside (an example is a package) and the chip can be prevented from being damaged.

According to one aspect of the present invention, preferably, there is provided a semiconductor device including: a chip having a base semiconductor layer, an insulation layer provided on the base semiconductor layer, and an upper semiconductor layer provided on the insulation layer; a mounting substrate on which the chip is mounted at the base semiconductor layer; and a connecting portion that electrically couples first terminals provided on the mounting substrate and a surface or second terminals provided thereon of the base semiconductor layer. The base semiconductor layer can be wire bonded, thereby making it easy to electrically couple the base semiconductor layer to the outside. The chip can be prevented from being damaged, since there is no bump used for mounting the chip.

### BRIEF DESCRIPTION OF THE DRAWINGS

Preferred exemplary embodiments of the present invention will be described in detail with reference to the following drawings, wherein:
FIG. 1A is a cross-sectional view of the semiconductor device of conventional example 1;
FIG. 1B is a cross-sectional view of the semiconductor device of conventional example 2;
FIG. 1C is a cross-sectional view of the semiconductor device of conventional example 3;
FIG. 2A is a cross-sectional view of the semiconductor device of conventional example 4;
FIG. 2B is a cross-sectional view of the semiconductor device of conventional example 5;
FIG. 3A is a cross-sectional view of a semiconductor device in accordance with a first exemplary embodiment of the present invention;
FIG. 3B is a cross-sectional view of a semiconductor device in accordance with a second exemplary embodiment of the present invention;
FIG. 3C is a cross-sectional view of a semiconductor device in accordance with a third exemplary embodiment of the present invention;
FIG. 3D is a cross-sectional view of a semiconductor device in accordance with a fourth exemplary embodiment of the present invention;
FIG. 4A is a cross-sectional view of a semiconductor device in accordance with a fifth exemplary embodiment of the present invention;
FIG. 4B is a cross-sectional view of a semiconductor device in accordance with a sixth exemplary embodiment of the present invention;
FIG. 4C is a cross-sectional view of a semiconductor device in accordance with a seventh exemplary embodiment of the present invention;
FIG. 5 is a top view of an angular velocity sensor chip;
FIG. 6A through FIG. 6E, FIG. 7A through FIG. 7D, and FIG. 8A through FIG. 8D are cross-sectional views of the angular velocity sensor, taken along lines A through K shown in FIG. 5;
FIG. 9A is a cross-sectional view of the semiconductor device in accordance with an eighth exemplary embodiment of the present invention; and
FIG. 9B is a top view of a connecting portion of FPC and the chip.

### DESCRIPTION OF THE PREFERRED EMBODIMENTS

A description will now be given, with reference to the accompanying drawings, of exemplary embodiments of the present invention.

### (First Exemplary Embodiment)

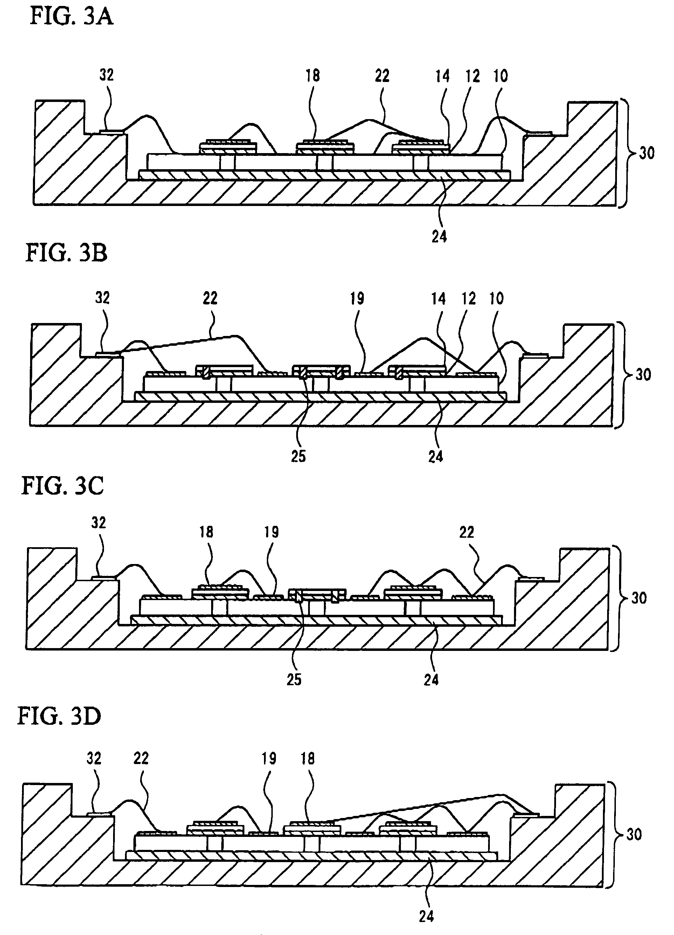

FIG. 3A is a cross-sectional view of a semiconductor device in accordance with a first exemplary embodiment of the present invention. A chip has a SOI structure including: a base semiconductor layer 10; an insulation layer 12 provided on the base semiconductor layer 10; and an upper semiconductor layer 14 provided on the insulation layer 12. The chip is mounted on a stacked package 30 by die bonding the stacked package 30 with the use of a bonding material 24 provided at the base semiconductor layer 10. The base semiconductor layer 10 and the upper semiconductor layer 14 are N-type silicon semiconductors in which arsenic or the like is doped. The insulation layer 12 is a silicon oxide film. The chip is an angular velocity sensor having double gimbal portions. The upper semiconductor layer 14 and the insulation layer 12 are removed to the base semiconductor layer 10 to expose the surface of the base semiconductor layer 10. The afore-described surface is connected to pads 32 of the stacked package 30 by wires. That is to say, the base semiconductor layer 10 is electrically coupled from the surface thereof to the stacked package 30 by wires 22 by way of openings formed in the upper semiconductor layer 14 and in the insulation layer 12. Electrodes 18 are formed on the upper semiconductor layer 14, and the base semiconductor layer 10 and the electrodes 18 are connected by the wires 22. The electrodes 18 are made of aluminum, and the wires 22 mainly include aluminum.

### (Second Exemplary Embodiment)

FIG. 3B is a cross-sectional view of a semiconductor device in accordance with a second exemplary embodiment of the present invention. In addition to the configuration employed in the first exemplary embodiment, electrodes 19 are provided on the base semiconductor layer 10, so wires 22 are bonded onto the electrodes 19. This can decrease the connection resistance between the base semiconductor layer 10 and the wires 22. In addition, connecting holes 25 that extend through the insulation layer 12 are provided to electrically couple the upper semiconductor layer 14 to the base semiconductor layer 10, instead of forming the electrodes 18 on the upper semiconductor layer 14. The upper semiconductor layer 14 is coupled to the stacked package 30 via the base semiconductor layer 10. This makes it possible to reduce the number of the wires and decrease the wire length.

### (Third Exemplary Embodiment)

FIG. 3C is a cross-sectional view of a semiconductor device in accordance with a third exemplary embodiment of the present invention. In addition to the configuration employed in the second exemplary embodiment, the electrodes 18 are provided on the upper semiconductor layer 14. The upper semiconductor layer 7.4 is coupled to the base semiconductor layer 10 by the connecting holes 25 and by wires, which connect the electrodes 18 and the electrodes 19.

### (Fourth Exemplary Embodiment)

FIG. 3D is a cross-sectional view of a semiconductor device in accordance with a fourth exemplary embodiment of the present invention. The electrodes 18 provided on the upper semiconductor layer 14 and the electrodes 19 provided on the base semiconductor layer 10 are coupled to the stacked package 30 by the wires 22, instead of providing the connecting holes 25 employed in the third exemplary embodiment. This makes it possible to eliminate the fabrication process of forming the connecting holes 25.

### (Fifth Exemplary Embodiment)

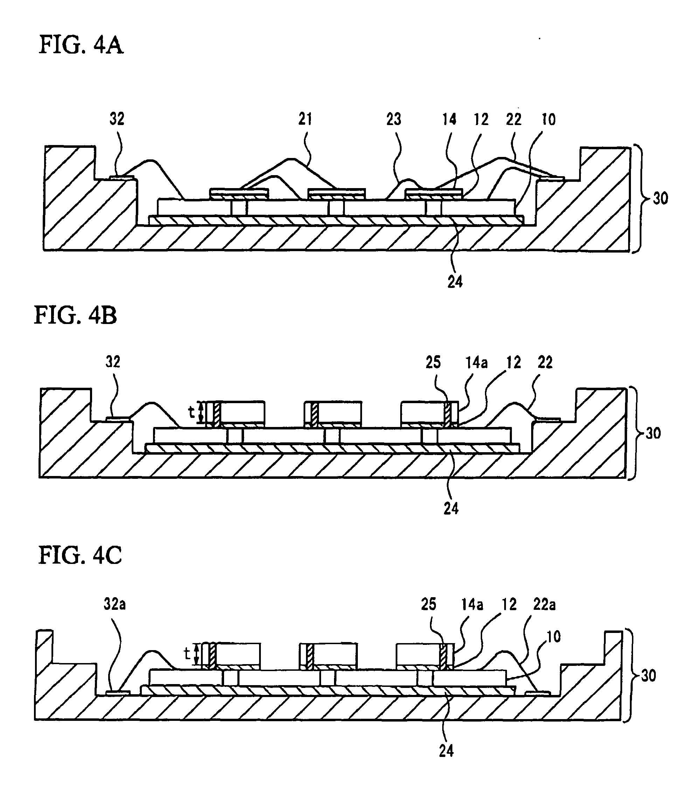

FIG. 4A is a cross-sectional view of a semiconductor device in accordance with a fifth exemplary embodiment of the present invention. The electrodes 18 and the electrodes 19 employed in the fourth exemplary embodiment are not provided. The wires 22 directly connect the upper semiconductor layer 14 and the base semiconductor layer 10. This makes it possible to eliminate the fabrication process of forming the electrodes.

### (Sixth Exemplary Embodiment)

FIG. 48 is a cross-sectional view of a semiconductor device in accordance with a sixth exemplary embodiment of the present invention. An upper semiconductor layer 14a has a thickness t, which is thicker than those of the upper semiconductor layers 14 employed in the first through fifth exemplary embodiments. The connecting holes 25 are provided in the insulation layer 12 to electrically couple the upper semiconductor layer 14a to the base semiconductor layer 10. The wires 22 are directly connected to the base semiconductor layer 10. The upper semiconductor layer 14a is coupled to the outside via the base semiconductor layer 10. In a case where the upper semiconductor layer 14a has a greater thickness as employed in the sixth exemplary embodiment and the wire 22 is connected to the upper semiconductor layer 14a, the length of the wire 22 becomes greater and the inductance is added. Besides, the height of the wire 22 becomes greater, thereby making it difficult to reduce the thickness of the package. Therefore, as described in the sixth exemplary embodiment, the aforementioned problems can be addressed by electrically coupling the upper semiconductor layer 14a to the stacked package 30 via the base semiconductor layer 10.

### (Seventh Exemplary Embodiment)

FIG. 4C is a cross-sectional view of a semiconductor device in accordance with a seventh exemplary embodiment of the present invention. Pads 32a of the stacked package 30 are provided on the die attach surface of the stacked package 30. This can lower the height of wires 22a, thereby reducing the thickness of the package.

According to the first through seventh exemplary embodiments, the pads 32 or 32a (first terminals) provided on the stacked package 30 (mounting substrate) are coupled to the surface of the base semiconductor layer 10 by way of openings formed in the upper semiconductor layer 14 and in the insulation layer 12, or are directly connected to the electrodes 19 (second terminals) provided on the surface of the base semiconductor layer 10 with the use of the wires 22 or 22a (connecting portion). Therefore, the base semiconductor layer 10 and the stacked package 30 do not have to be connected, whereas the base semiconductor layer 10 and the stacked package 30 are directly connected in the conventional example 1. This prevents the inductance from being added, and eliminates the area for the connecting holes. In this manner, it becomes easy to electrically couple to the outside. In addition, the bumps 26 do not have to be formed to connect the base semiconductor layer 10 and the stacked package 30, whereas the bumps 26 are provided in the conventional examples 3 through 5. Accordingly, it is possible to prevent, for example, the driving portion included in the chip from being damaged during the bump-forming process. This can prevent the chip from being damaged. Furthermore, the mounting surface can be inspected, after the chip is mounted.

In addition, according to the fourth and fifth exemplary embodiments, the wires 22 are directly connected to the upper semiconductor layer 14 and the surface of the base semiconductor layer 10, or are electrically coupled to the upper semiconductor layer 14 and the surface of the base semiconductor layer 10 by way of the electrodes 18 and 19. This eliminates the necessity of electrical coupling through the base semiconductor layer 10, when the upper semiconductor layer 14 is connected with the stacked package 30. This prevents the inductance from being added, and eliminates the area for the connecting holes.

Furthermore, according to the second, sixth, and seventh exemplary embodiments, the connecting holes 25 (electrically coupling portion) that connect the upper semiconductor layer 14 and the base semiconductor layer 10 are provided, and the wires 22 are electrically coupled to the upper semiconductor layer 14 via the base semiconductor layer 10. This makes it possible to reduce the number of the wires 22. This also reduces the fabrication process of forming the electrodes 18. Additionally, the heights of the wires 22 can be reduced, thereby reducing the thickness of the package.

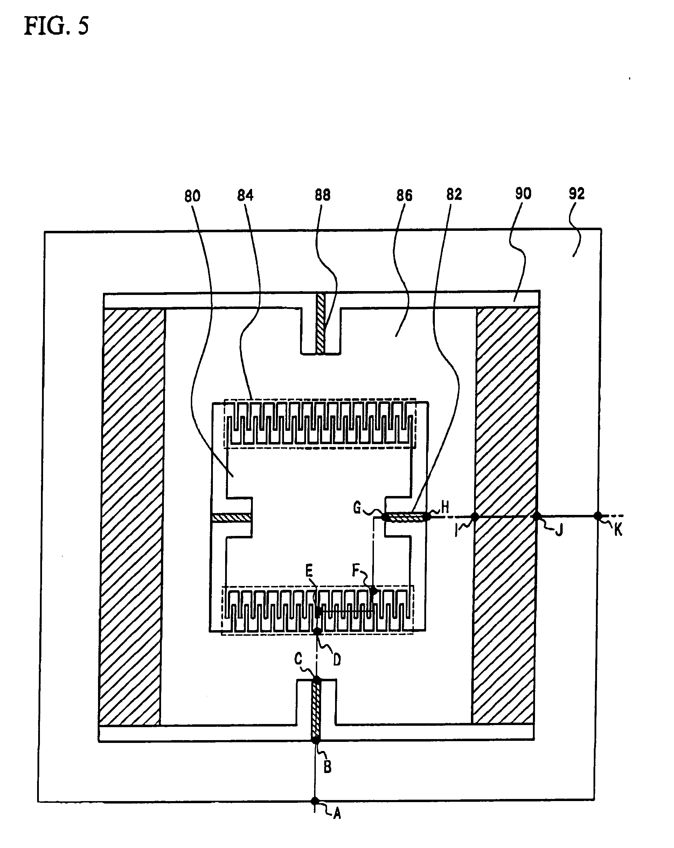

Next, a description will be given of an angular velocity sensor chip employed in the first through seventh exemplary embodiments and a fabrication method thereof. FIG. 5 is a top view of the angular velocity sensor chip. Referring to FIG. 5, a first gimbal portion 80 is mechanically connected to a second gimbal portion 86 by first torsion bars 82 formed at a pair of side surfaces thereof that oppose each other. Comb-teeth electrodes 84 are arranged at the other pair of the side surfaces that oppose each other. Each one of the comb-teeth electrodes 84 is fixed to the first gimbal portion 80, and each of the other comb-teeth electrodes 84 is fixed to the second gimbal portion 86. The second gimbal portion 86 is mechanically connected to a frame portion 92 by second torsion bars 88 formed at a pair of side surfaces thereof that oppose each other. Parallel plane plate electrodes 90 are arranged at the other pair of the side surfaces that oppose each other. Each one of the parallel plane plate electrodes 90 is fixed at the second gimbal portion 86, and each of the other parallel plane plate electrodes 90 is fixed at the frame portion 92.

The first gimbal portion 80 is vibrated by applying a voltage alternatively to the left and right comb-teeth electrodes 84. Then, the angular velocity is detected. Subsequently, the parallel plane plate electrodes 90 detect the vibration of the second gimbal portion 90. As stated, the parallel plane plate electrodes 90 serving as a detection portion that detects the vibration and the comb-teeth electrodes 84 serving as the driving portion that excites the vibration are respectively arranged at the first gimbal portion 80 and the second gimbal portion 86. The torsion bars 82 and 88 that retain the afore-described driving portions and the gimbal portions 80 and 86 have a minute structure, and are easily damaged during the bump-forming process.

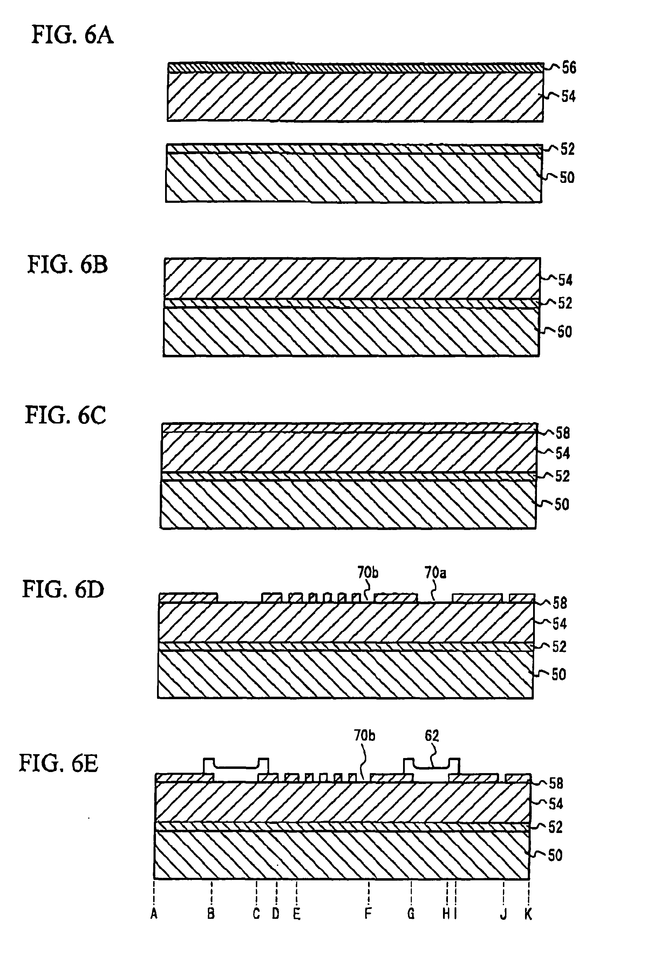

Next, a description will be given of a fabrication process of the angular velocity sensor, with reference to FIG. 6A through FIG. 6E, FIG. 7A through FIG. 7D, and FIG. 8A through FIG. 8D. FIG. 6A through FIG. 6E, FIG. 7A through FIG. 7D, and FIG. 8A through FIG. 8D are cross-sectional views of the angular velocity sensor, taken along lines A through K shown in FIG. 5. A-B corresponds to the frame portion 92, B-C corresponds to the second torsion bar 88, C-D corresponds to the second gimbal portion 86, D-E and E-F correspond to the comb-teeth electrodes 84, F-G corresponds to the first gimbal portion 80, G-H corresponds to the first torsion bar 82, H-I corresponds to a portion of the second gimbal portion 86, I-J corresponds to the parallel plane plate electrode 90, and J-K corresponds to the frame portion 92.

Referring to FIG. 6A, silicon oxide films 52 and 56 are formed to have a thickness of 500 nm by thermally oxidizing the surfaces of the silicon substrates 50 and 54, into which arsenic or the like is doped to have a low resistivity of approximately 0.01 Ωcm to 0.1 Ωcm. Referring to FIG. 6B, the silicon oxide films 52 and 56 are sealed together and the thermal treatment is performed at approximately 110 °C. This bonds the silicon oxide films 52 and 56 to form an integrally formed silicon oxide film 52. The silicon substrates 50 and 54 are polished, so that each has a thickness of approximately 100 µm. Thus, an SOI substrate of a structure includes: the silicon substrate 54 (hereinafter, referred to as base semiconductor layer 54); the silicon oxide film 52 (hereinafter, referred to as the insulation film 52); and the silicon substrate 50 (hereinafter, referred to as upper semiconductor layer 50), with respective thicknesses of 100 µm / 1 µm / 100 µm.

Referring now to FIG. 6C, a silicon oxide film having a thickness of approximately 100 nm to 1000 nm is formed on the base semiconductor layer 54, as an etch mask layer 58. Referring to FIG. 6D, openings 70a and 70b are formed in regions to be etched (the regions that become the torsion bars, the comb-teeth electrodes, and the parallel plane plate electrodes) of the base semiconductor layer 54 with the use of the etch mask layer 58. Referring to FIG. 6E, a photoresist 62 is formed in the opening 70a (the region that becomes the torsion bar).

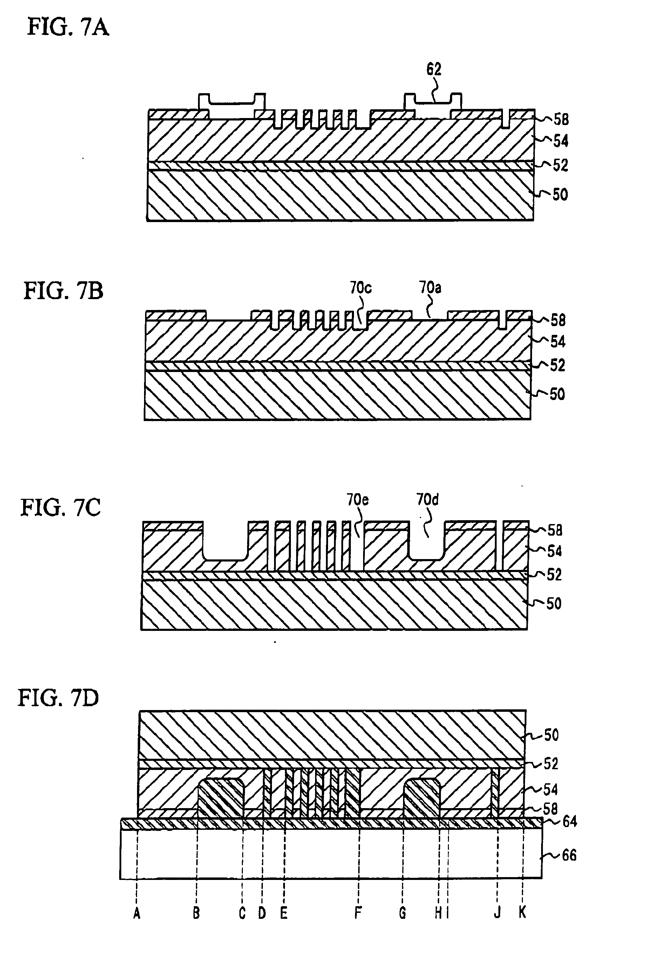

Referring to FIG. 7A, the semiconductor layer 54 is etched by approximately 30 µm to 40 µm by using the mask layer 58 and the photoresist 62 as masks. Wet etching is performed with the use of a hydrofluoric acid (HF)-based solution or RIE etching with the use of SF₆ and C₄F₈. Referring to FIG. 7B, the photoresist 62 is removed. Referring to FIG. 7C, the base semiconductor layer 54 is etched with the mask later 58 as a mask. RIE etching is performed with the use of SF₆ and C₄F₈. Thus, a recess 70e that reaches the insulation layer 52 is formed in the base semiconductor layer 54. A recess 70d is formed in the region that becomes the torsion bar, with leaving the base semiconductor layer 54 by approximately 30 µm. Referring to FIG. 7D, a photoresist 64 is embedded in the recesses 70d and 70e formed in the base semiconductor layer 54, and is bonded to a substrate 66 for handling.

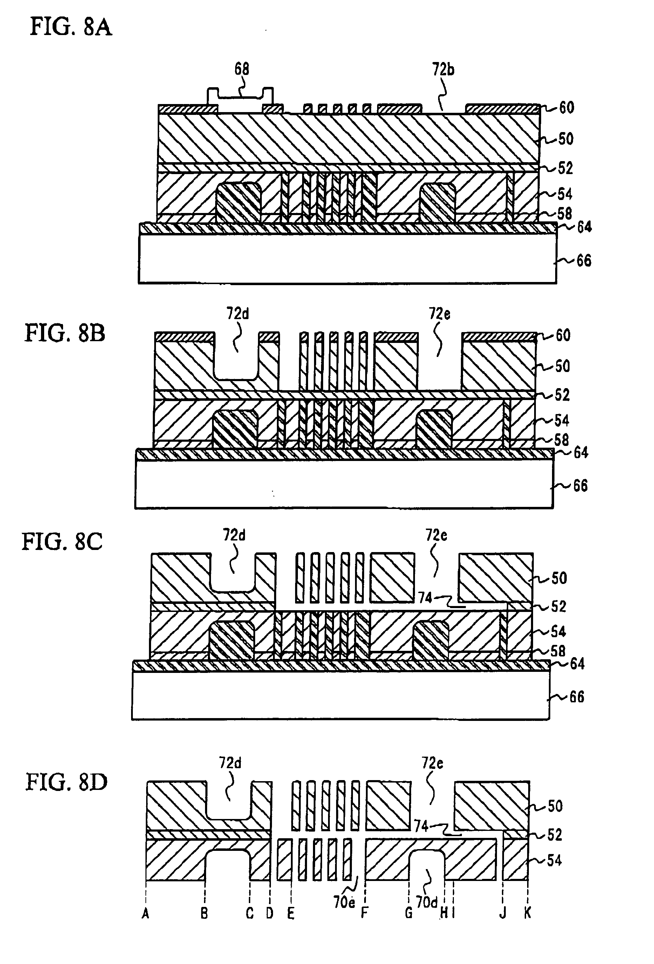

Referring to FIG. 8A, a silicon oxide film is formed on the upper semiconductor layer 50 as a mask layer 60, in a similar manner as shown in FIG. 6C through FIG. 6E. An opening 72b is formed in a given region of the mask layer 60. A photoresist 68 is formed in the region that becomes the torsion bar. The upper semiconductor layer 50 is etched by approximately 30 µm to 40 µm by using the mask layer 60 and the photoresist 68 as masks, in a similar manner as shown in FIG. 7B and FIG. 7C. The photoresist 68 is removed and the upper semiconductor layer 50 is etched with the use of the mask layer 60 as a mask. Thus, a recess 72e that reaches the insulation layer 52 is formed in the upper semiconductor layer 50. A recess 72d is formed in the region that becomes the torsion bar, with leaving the base semiconductor layer 54 by approximately 30 µm.

Referring to FIG. 8C, a given region of the insulation film 52 and the mask layer 60 are removed by the hydrofluoric acid (HF)-based solution. Referring to FIG. 8D, the substrate 66 for handling is peeled off, and the photoresist 64 and the mask layer 58 are removed. In this manner, the angular velocity sensor chip is fabricated.

The base semiconductor layer 54, the insulation layer 52, and the upper semiconductor layer 50 respectively correspond to the base semiconductor layer 10, the insulation layer 12, and the upper semiconductor layer 14 shown in FIG. 3A through FIG. 4C. The angular velocity sensor chip is mounted on the die attach portion of the stacked package 30 at the base semiconductor layer 10 with the use of the bonding material 24 such as silver paste, for example. The electrodes 18, the electrodes 19, the base semiconductor layer 10, or the upper semiconductor layer 14 are wire bonded to the pads 32 or 32a and connected to the pads 32 or 32a of the stacked package 30. A cap is attached to the stacked package 30, so a semiconductor device on which the angular velocity sensor is mounted is completed.

### (Eighth Exemplary Embodiment)

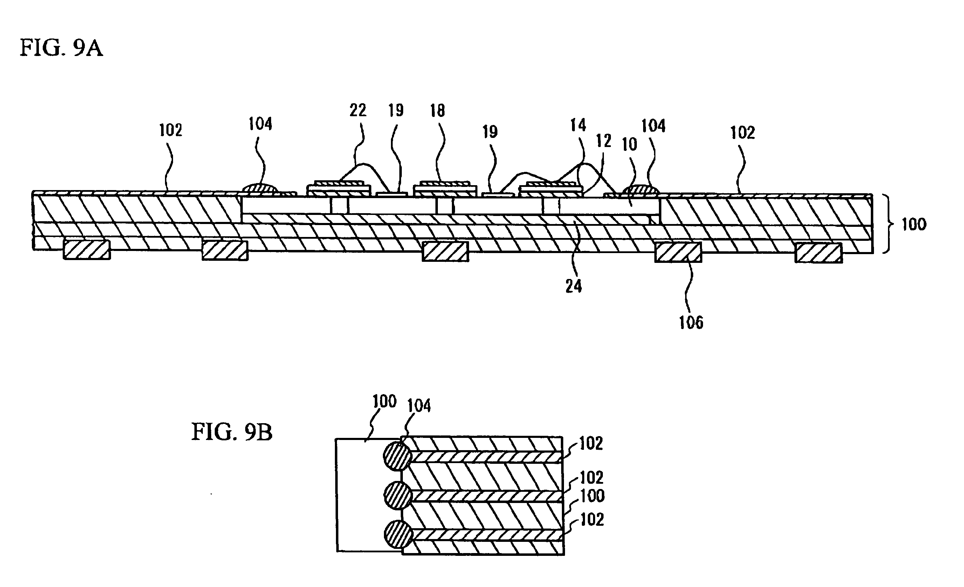

An eighth exemplary embodiment is an example of a semiconductor device mounted on a flexible printed circuit board (FPC). FIG. 9A is a cross-sectional view of the semiconductor device in accordance with an eighth exemplary embodiment of the present invention. FIG. 9B is a top view of a connecting portion of FPC and the chip (the electrodes 19 are not shown). In the eighth exemplary embodiment, the chip to be mounted is same as that employed in the fourth exemplary embodiment, and the same components and configurations as those of the fourth exemplary embodiment have the same reference numerals and a detailed explanation will be omitted. The above-described chip is die bonded and mounted on a FPC 100 with the use of the bonding material 24. Copper wirings 102 are formed in the surface of the FPC 100, and are provided to reach the base semiconductor layer 10. The electrodes 19 and the copper wirings 102 are connected by solder pastes 104. There are provided external terminals 106 on the backside of the FPC 100. The copper wirings 102 are coupled to the external terminals 106 by connecting holes (not shown) provided in the FPC 100. With such configuration, the external terminals 106 (first terminals) provided at the FPC 100 (mounting substrate) are electrically coupled to the electrodes 19 (second terminals) provided on the surface of the base semiconductor layer 10 by the copper wirings (connecting portion).

In the first through eighth exemplary embodiments, a description has been given of the case where the metal wires 22 and the wiring of the flexible printed circuit board that serve as the connecting portion electrically coupling the surface of the base semiconductor layer 10 or the electrodes 19 on the surface of the base semiconductor layer 10 to the stacked package 30. As the connecting portion, another portion may be employed, if it couples the base semiconductor layer 10 and the mounting substrate. As the mounting substrate that mounts the chip, a description has been given of the cases of the stacked package and the flexible printed circuit board. However, if the substrate mounts the chip, a stacked ceramic substrate, a printed board, or the like may be employed. As the driving portion, a description has been given of the example of the sensor having the gimbal portion and the like. It is only necessary that the driving portion drive mechanically, such as an actuator, for example. In the semiconductor device having the above-described driving portion, it is possible to prevent the driving portion from being damaged during the bump-forming process, by applying the present invention. In addition, it is possible to prevent a minute mechanical structure such as the torsion bar from being damaged in a similar manner.

Finally, various aspects of the present invention are summarized in the following.

According to one aspect of the present invention, there is provided a semiconductor device including: a chip having a base semiconductor layer, an insulation layer provided on the base semiconductor layer, and an upper semiconductor layer provided on the insulation layer; a mounting substrate on which the chip is mounted at the base semiconductor layer; and a connecting portion that electrically couples first terminals provided on the mounting substrate and a surface or second terminals provided thereon of the base semiconductor layer.

In the above-described semiconductor device, the chip may include a driving portion. In the semiconductor device having a driving portion that is easily damaged by mounting with the use of the bumps, the chip can be prevented from being damaged.

In the above-described semiconductor device, the connecting portion may be a metal wire or a wiring of a flexible printed circuit board.

In the above-described semiconductor device, the connecting portion may electrically couple the upper semiconductor layer and the surface of the base semiconductor layer. It is not necessary to electrically couple the upper semiconductor layer to the outside through the base semiconductor layer.

The above-described semiconductor device may further include an electrically coupling portion that electrically couples the upper semiconductor layer and the base semiconductor layer, and the connecting portion may electrically couple the chip and the upper semiconductor layer through the base semiconductor layer. It is possible to reduce the fabrication process, thereby reducing the thickness of the package.

The present invention is not limited to the above-mentioned exemplary embodiments, and other exemplary embodiments, variations and modifications may be made without departing from the scope of the present invention.

The present invention is based on Japanese Patent Application No. 2005-231363 filed on August 09, 2005, the entire disclosure of which is hereby incorporated by reference.

## Claims

1. A semiconductor device comprising:
a chip having a base semiconductor layer, an insulation layer provided on the base semiconductor layer, and an upper semiconductor layer provided on the insulation layer;
a mounting substrate on which the chip is mounted at the base semiconductor layer; and
a connecting portion that electrically couples first terminals provided on the mounting substrate and a surface or second terminals provided thereon of the base semiconductor layer.

2. The semiconductor device as claimed in claim 1, wherein the chip includes a driving portion.

3. The semiconductor device as claimed in claim 1, wherein the connecting portion is a metal wire or a wiring of a flexible printed circuit board.

4. The semiconductor device as claimed in claim 1, wherein the connecting portion electrically couples the upper semiconductor layer and the surface of the base semiconductor layer.

5. The semiconductor device as claimed in claim 1, further comprising an electrically coupling portion that electrically couples the upper semiconductor layer and the base semiconductor layer,
wherein the connecting portion electrically couples the chip and the upper semiconductor layer through the base semiconductor layer.
